# EUROPEAN PATENT APPLICATION

(11) **EP 4 815 643 A1**
(43) Date of publication of application: **30.09.2026**
(21) Application number: 25166815.8
(22) Date of filing: 27.03.2025
(51) Int. Cl.: H05K 1/18, H05K 3/46

(54) **COMPONENT CARRIER WITH A COUNTER-ELEMENT AND METHOD FOR MANUFACTURING THEREOF**

(71) Applicant: AT & S Austria Technologie & Systemtechnik Aktiengesellschaft, 8700 Leoben-Hinterberg (AT)
(72) Inventor: KIRCHHEIMER, Karl Philipp, 8700 Leoben (AT)
(74) Representative: Donatello, Daniele

(57) **Abstract**

The invention relates to a component carrier (1) comprising a stack (2) with at least one electrically conductive layer structure (3) and a plurality of electrically insulating layer structures (4,5), wherein at least one first electrically insulating layer structure (4) is provided at a first main side (6) of the stack (2) and at least one second electrically insulating layer structure (5) is provided at an opposed second main side (7) of the stack (2).

At least one component (8) is embedded in the at least one first electrically insulating layer structure (4); wherein at least one counter-element (9) is embedded in the at least one second electrically insulating layer structure (5), wherein said at least one counter-element (9) is configured and positioned to affect the stack (2) in opposition of the embedded component (8).

## Description

The invention relates to a component carrier comprising a stack of a plurality of layers forming at least one electrically conductive layer structure and a plurality of electrically insulating layer structures. The invention also relates to a component carrier assembly and to a method for manufacturing a component carrier.

Component carriers according to the prior art comprises different elements and components that are arranged inside the component carrier, especially arranged between its conductive layers and insulating layers. The embedding of such components between layers with respect to the prior art often results in a negative warpage behavior of the whole structure of a component carrier. In many cases, a symmetric structure has to be provided in order the overcome the warpage behavior.

A disadvantage of the prior art is that the structures of the prior art which are used to compensate those effects often do not influence the warpage sufficiently and may also negatively influence the possibility of providing different designs of the component carrier, in particular with respect to an arrangement of components and a possible provision of their further functional features in a component carrier.

It has been the object of the present invention to overcome the disadvantages of the prior art and to provide a component carrier assembly of which an influence of at least one component on the stack with respect to a warpage can be minimized or compensated; wherein the quality of the component carrier can also be enhanced.

This object is achieved by a component carrier; comprising
- a stack comprising at least one electrically conductive layer structure and a plurality of electrically insulating layer structures ,
   - wherein at least one first electrically insulating layer structure is provided at a first main side of the stack
   - at least one second electrically insulating layer structure is provided at an opposed second main side of the stack
   - at least one component that is embedded in one between the at least one first electrically insulating layer structure and the at least one second electrically insulating layer structure;
   - at least one counter-element that is embedded in the other one of the at least one first electrically insulating layer structure and the at least one second electrically insulating layer structure , wherein said at least one counter-element is configured and positioned to affect the stack in opposition of the embedded component.

By providing the at least one counter-element in opposition to the component, the warpage behavior can be compensated in a simple and effective manner. Furthermore, the function realized by the counter-element can be provided with respect to any individual position of the component in the component carrier. Therefore, a symmetrical structure of the stack of the component carrier in order to avoid the warpage may not be needed, which enables further possibilities for the design of the component carrier.

Due to the opposite arrangement, the influence caused by the counter-element can be applied more easily and at the same time more variably; and in particular, the function of the counter-element can be implemented much more precisely due to the possibility of individually determining its position on the opposite main side.

The affection caused by the counter-element can preferably act in a physical manner.

In particular, the counter-element can be provided to counterbalance a physical influence of the component on the stack. Preferably the counter-element can be configured that its physical properties counterbalance the physical properties of the respective component. The counter-balance can also be formed by a combination of the physical properties with; the respective position of the counter-element and the component and/or a geometric shape of the counter-element and the component.

For example, the affection may relate to a warpage of the stack that is caused by the component, in particular the physical properties, for example the coefficient of thermal expansion (CTE), of the component; wherein the counter-element may cause the same or a similar warpage in opposition, preferably related to the physical properties, for example the coefficient of thermal expansion (CTE), of the counter-element, so that so that the warpage caused by the component can be minimized; or preferably neutralized. Thereby, the total warpage of the stack may be minimized.

Preferably, the at least one counter-element can be configured and positioned to mechanically affect the stack in opposition of the mechanical affection of the stack by the embedded at least one component. Preferably, the mechanical affection of the counter-element on the stack may be similar as the mechanical affection of the at least one component on the stack. In an example, the mechanical affection of the counter-element on the stack may be in one direction, whereas the mechanical affection of the at least one component on the stack may be in the opposed direction. This may counter-balance the affection of the counter-element and the affection of the component and thus may efficiently reduce the warpage behavior of the stack, especially being pronounced in one direction.

A further advantage of the invention is that the layer structure can be stiffened or reinforced locally at the same time by means of the counter-element, which can improve or adjust the stability of individual layers.

In addition, the invention can be used to improve a weight distribution in the component carrier, which means that the component can be better integrated into further assemblies.

According to a possible embodiment the at least one component may be electrically connected to at least one of the main sides of the stack. Preferably, the component may be electrically connected to the first main side and/or the opposed second main side of the stack, in particular via the at least one electrically conductive layer structure. This may ensure to supply electric current to the embedded component through the stack by a connection with a first main side and/or oppose second main side.

Furthermore, the at least one counter-element can be electrically insulated from the electrically conductive layer structures of the stack. This may bring the advantage of simplifying the manufacturing process, since no electrical connection to the counter-element is needed to impart the mechanical affection of the at least one component on the stack. Additionally or alternatively, the at least one counter-element can be electrically connected to the electrically conductive layer structures of the stack.

In one embodiment at least one counter-element may not be connected with a surface of the component carrier. This may bring the advantage of having a compact component carrier. Preferably, the surface comprises an electrically conductive layer structure being configured for being connected to an interposer and/or IC substrate. Thus the surface of the component carrier may be efficiently used without the occupation of the counter-element. In an example, the at least one counter-element may not be directly connected with a surface of the component carrier.

According to one preferred embodiment, the at least one component can be embedded in a first cavity that is formed in the at least one first electrically insulating layer structure and the at least one counter-element can be embedded in a second cavity that is formed in the at least one second electrically insulating layer structure. This may bring the advantage of making the component carrier more compact. Additionally or alternatively, the closer the component and/or the counter-element is located to the center of the stack in regard to thickness direction, the less prominent may be overall warpage of the component carrier. For this reason, embedding the component and/or the counter-element and thus distancing the aforementioned elements from the surface may be advantageous.

Furthermore, the at least one component and/or the at least one counter-element can be embedded in a cavity that is formed in a plurality of the electrically insulating layer structures. Preferably, the at least one component may be embedded in a plurality of one between the at least one first electrically insulating layer structure and the at least one second electrically insulating layer structure and/or the at least one counter-element may be embedded in a second cavity that is formed in a plurality of the other one of the at least one first electrically insulating layer structure and the at least one second electrically insulating layer structure. This may bring the advantage of further minimizing the overall warpage behavior of the component carrier, since the size and/or the location of the counter-element may be chosen optimally.

According to a possible modification; one of the elements; comprising i) the at least one component and ii) the at least one counter-element; can be embedded in the plurality of the first electrically insulating layer structures or the second electrically insulating layer structures, and whereby the other one can be embedded in one of the first electrically insulating layer structure or the second electrically insulating layer structure.

The at least one counter-element may be in contact with at least one electrically conductive layer structure of the stack. Preferably, the at least one counter-element may be in direct contact with at least one electrically conductive layer structure. This may create a counter-element being composed of a plurality of materials. Additionally or alternatively, the may bring the advantage of modifying the overall physical property, in particular the CTE, of the at least one counter-element. Thus this may give the possibility of creating a counter-element having a tailored CTE value.

According to a possible embodiment, a plurality of counter-elements can be provided for the at least one component. Also, a plurality of components can be provided with respect to the at least one counter-element. According to this feature, it can also be possible that e.g.: 3 components and 3 counter-elements are present, whereby two of the counter-elements are provided to affect one of the components and whereby the third counter-element can affect the other two components. For the sake of completeness, it should be mentioned that an unequal number of counter-elements and components can be provided; for example, one component affected by two counter-elements in total. The number of counter-elements provided for the at least one component may depend of the corresponding CTE values of the counter-elements and the component. For example, the CTE value mismatch between the counter-element and the component may be too large in order that a plurality of counter-elements is required to counter-balance the warpage affection of the component. In an example each of the plurality of counter elements may have the same physical property, in particular CTE value. In another example, each of the plurality of counter elements may have a different physical property, in particular CTE value, compared one to the other.

Furthermore, the counter-element(s) and the component(s) may have a different shape to each other, for example, one may have a greater (vertical and/or planar) extension and/or may have a different material. For example, two small counter-elements may be provided for a bigger component (or vice versa). As a further possible example, a small counter-element can be provided for a bigger component, whereby the material of counter-element may have a higher stiffness or a higher density than the material of the component. This may give the possibility to effectively counter-acting the warpage behavior of the stack affected by components having different shape or size by counter-elements having comprising different material and/or extension in regard to the component.

According to a further possible embodiment, a plurality of components may be provided on at least one main side; or on both main sides of the stack, wherein several respective counter-elements are provided on the respective opposed main sides of the stack for each component of the plurality of components. An arrangement of multiple counter-elements and components on each of the main sides can also be possible.

Preferably, the total number of the components and number of counter-elements can be equal. Alternatively, the total number of the components and number of counter-elements can also be unequal, as mentioned before.

According to one embodiment; at least one of the respective counter-elements of the plurality of counter-elements can have a different vertical extension and/or planar extension (width) with respect to the at least one component. For example, the height and/or width of the counter-element can be different to the height and/or width of the component. The planar extension may be different in multiple directions with respect to a main extension of the stack; for example, referring to a length and a width of the counter-element (or component) from a top view perspective of the stack. This may bring the advantage of adjusting and/or counter acting the warpage behavior affected by the counter-element more effectively in comparison to the affection of the component in regard to the warpage on the stack.

At least one of the respective counter-elements of the plurality of counter-elements may have a different vertical extension and/or planar extension with respect to at least one other counter-element of the plurality of counter-elements. At least two counter-elements may have different height and/or width to each other. This may bring the advantage of spatially directing the affection of the counter-elements in regard to warpage, since different vertical extensions and/or planar extensions of the counter-elements may change the overall warpage behavior of the sum of the counter-elements.

The at least one counter-element may comprise at least one of the following (active or passive) elements;
- a component; in particular an electric component or a bridge;
- a dummy component;
- a component for testing purposes in particular a daisy-chain component
- a metal structure;
- a layer structure; in particular an inlay;
- at least one second conductive layer structure with a different (higher) density (with respect to the at least one electrically conductive layer structure) ;
- a sub-stack, in particular an interposer.

This may bring the advantage of bringing a further function to the stack and thereby take advantage of the physical property of the counter-element in order to minimize the overall warpage of the stack.

The preferred embodiment of counter-element may comprise the dummy component. Furthermore, the dummy component may be composed by a single material.

The counter-element may also have a simple geometrical shape, like a cuboid, or a disk with a rectangular or circular shape for example.

The counter-element may have at least one concave surface and/or at least one convex surface. The counter-element may also have at least one inclined surface.

The counter-element may comprise a surface modification to improve its embedding in the stack. The surface modification may comprise a higher roughness. In case of a dummy, the surface modification may be already achieved by a forming step of the dummy.

The material of the counter-element may comprise silicon. Further possible materials may be, but not limited to, metals, or also ceramic materials, for example silicon carbide, silicon nitride, aluminum nitride, or ceramic glass. The counter-element may consist of only one material. Additionally or alternatively, the counter-element may comprise glass and/or organic polymeric material, for example epoxy resin. Depending on the requirements, in particular the affection of the component, a proper material (mixture) of the counter-element can be chosen.

The component carrier, in particular the stack, may comprise a central structure between the at least one first electrically insulating layer structure and the at least one second electrically insulating layer structure. Preferably, the central structure may have a different thickness than the first electrically insulating layer structure and/or the second electrically insulating layer structure. Optionally, the central structure may have the same thickness as the first electrically insulating layer structure and/or the second electrically insulating layer structure. The central structure may bring a further function to the component carrier, since it may comprise further components. Additionally or alternatively, the central structure may comprise material being different than the first electrically insulating layer structure and/or the second electrically insulating layer structure, for example glass and/or ceramic material, and thus may impart a stiffening feature to the stack and thus may reduce the overall warpage of the component carrier. The central structure may comprise one layer structure or a plurality of layer structures.

The central structure may comprise electrically conductive layer(s) and/or electrically insulating layer(s). The central structure could be made of electrically insulating material, e.g. organic polymeric material and/or a ceramic material or a glass.

Preferably, the component carrier may comprise the same amount of layer structures on one side of the central structure with respect to the amount of layer structures on the other side of the central structure. Such a symmetric construction of the component carrier may reduce the warpage behavior of the entire component carrier, since a symmetrical construction of the layer structures above and below the central structure in regard to thickness direction balances out the impact of the affection in regard to warpage of the layer structure(s) above the central structure in regard to the impact of the affection in regard to warpage of the layer structure(s) below the central structure.

The component carrier may comprise a core structure between the at least one first electrically insulating layer structure and the at least one second electrically insulating layer structure. The central structure may comprise the core - or may only consist of the core.

A core structure can preferably be a provided element which has at least one electrically insulating layer and preferably at least one electrically conductive layer. The core structure may comprise reinforcing structures, for example glass fibers or glass spheres, and may be in a fully cured stage. Thus, it may provide mechanical stability to the stack. Additionally or alternatively, the core structure may temper the affection of the layer structures above and/or below the core structure in regard to warpage due to its stiffness of the core structure.

The core structure may comprise a multilayer structure; comprising a plurality of electrically insulating layer structures and/or electrically conductive layer structures.

Preferably, the at least one first electrically insulating layer structure may be provided at a first side of the core structure (at the first main side) and the at least one second electrically insulating layer structure may be provided at an opposed second side of the core structure (at the second main side).

The at least one first electrically insulating layer structure and/or the at least one second electrically insulating layer structure can be provided by a build-up structure on at least one side of the core structure.

The build-up structure may be provided by forming additional layer structure(s) on the core structure. The build-up structure can be formed by layers with semi-cured material which has the ability to flow and fill up cavities or the like, for example by applying heat and/or pressure. Preferably, the core structure may comprise the same material as the build-up structure. In an example, the build-up structure may comprise organic polymeric material, for example epoxy resin. Additionally the build-up structure may comprise reinforcing material, for example glass fibers. Preferably the build-up structure may extend over an entire layer in order to for a build-up layer. Additionally or alternatively, the stack may comprise the build-up structure.

The build-up layer structure (s) may also comprise a conductive layer structure. Preferably, the build-up layer structure may comprise electrically conductive material, in particular an electrically conductive layer structure, for example copper. This may bring the advantage of forming electrically conductive traces which may also impact the overall warpage of the stack and thus may also be used to counter balance the overall warpage of the component carrier.

According to a possible embodiment; at least one inner cavity can be formed in the central structure and/or in the core structure.

A further component can be embedded in that inner cavity that is formed in the central structure and /or in the core structure. The further component may be a component as described before. This may bring the advantage of imparting a further function to the component carrier, while at the same time keeping the extension of the component carrier very compact.

The component carrier may comprise a coreless structure.

In one embodiment; the surfaces of the opposed respective at least one component and the at least one counter-elements may at least partially overlap one to each other from a frontal vertical view (in relation to the stack). This may bring the advantage of counter acting the warpage affection imparted by the component in regard to warpage in the opposed direction by the warpage affection imparted by the counter-element in regard to warpage.

A ratio of the volume of the at least one component with respect to the volume of the at least one respective counter-element may not exceed a difference of 30%. Preferably, the at least one component and the at least one counter-element may comprise similar material, the volume of the aforementioned elements may not differ than more than 30% one to each other in order to effectively counter-balance the affection in regard to warpage one to each other. Additionally or alternatively, a ratio of the volume of the at least one component with respect to the (combined) volume of the respective plurality of counter-elements may not exceed a difference of 30% and/or a ratio of the (combined) volume of the plurality of components with respect to the volume of the at least one counter-element may not exceed a difference of 30%.

Both, the material of the at least one component compared to the material of the at least one respective counter-element, may have a young module and/or a Coefficient of Thermal Expansion that differs from each other by a maximum of 50%. The young module and/or a Coefficient of Thermal Expansion can refer to the resulting properties of the component or the counter-element if it consists of multiple elements and/or materials. For manufacturing reasons, it is easier and less time consuming to embed a component and a counter-element have the same size one to each other. In order to achieve a low overall warpage of the component carrier, it may be beneficial that the difference of the related CTE values do not differ more than 50% from each other, in particular not more than 30%.

According to an embodiment, a vertical position and/or a horizontal position of the at least one component and/or the respective at least one counter-element can be decentered towards a respective external surface of the stack with respect to a center plane of said stack. Even if the design of the component carrier does not allow a centered arrangement of the component with the counter-element, the decentered alignment of the component and the counter-element in combination with their (respective different) CTE values may with the possibility to reduce the overall warpage of the component carrier.

A vertical position of the at least one component and/or the respective at least one counter-element may be referred to the respective external surface of the stack, that is parallel to the first main surface (or the second main surface). Therefore, the respective first center plane with respect the decentered vertical position towards an external surface may be a horizontal plane, preferably parallel to the first main surface.

A horizontal position of the at least one component and/or the respective at least one counter-element may be referred to the respective external surfaces of the stack which are perpendicular to the first main surface or the second main surface. The decentered horizontal position may be provided in at least one direction that can be parallel to the first main surface or the first center plane. Therefore, a respective second center plane with respect to the decentered horizontal position towards an external surface may be a vertical plane preferably perpendicular to the first main surface.

Furthermore, there may be also a horizontal decentered position with respect to a further (third) center plane with respect to the external surface arranged perpendicular the second center plane and also perpendicular the first center plane.

For the sake of completeness, it should be mentioned that the first center plane is preferably aligned horizontally (e.g. according to a "horizontal" main extension of the layers of the stack). The center plane can be arranged in a middle between the first main side and the second main side.

The at least one component and the respective counter-element can preferably be mirrored-placed one to each other with respect to a center plane of the stack. This may maximize the affection of the counter-element in regard to warpage behavior in comparison to the affection of the component in regard to warpage behavior.

Preferably the planar extension of the at least one counter-element can at least partially (inversely) overlap the planar extension of the at least one component.

In a further embodiment the volume of the counter-elements can (inversely) overlap the volume of the respective at least one component, of at least 50 % of the volume of the component. Such an overlap of the volume of the counter-element with the volume of the component may ensure that similar dimension/extension of the counter-element in regard to the component can be used and thus may simplify the manufacturing process and therefore may save time.

The respective volume can be provided the space that the component or the counter-element geometrically occupies in the respective electrically insulating layer structure.

According to one embodiment the at least one component can be embedded at the same position in an inverse order of at least one layer structure with respect to the position of at least one layer structure(s) where the at least one counter-element is embedded. The inverse order can relate to a vertical direction that extends through the layer structures on the first main side with respect to the layer structures on the second main side.

In a possible embodiment, the at least one component and the at least one counter-element may have the same geometrical shape, in particular with respect to their outer contour, preferably mirrored to each other (with respect to a center plane as mentioned before). Such a similar geometrical shape between the counter-element and the component may ensure that the affection of the counter-element and the affection of the component in regard to the overall warpage of the component carrier counter act each other, preferably in opposed directions.

According to a preferred embodiment at least one further structural element can be provided in an area of the at least one counter-element, wherein the structural element is configured to affect the stack in opposition of a part of the electrically conductive layer structure in an area of the at least one component. Therefore, a structural element or an arrangement of structural elements can be provided. The structural element(s) can be configured to counterbalance the physical properties of the electrically conductive layer structure in opposite side of the stack. This embodiment has the advantage, that an additional influence can be provided with an easy method to balance the stack in relation to the electrically conductive layer structure that is provided in the area of the component, which can preferably be connected with the component.

The structural element(s) may be formed on an outer surface of the at least one counter-element. The structural element(s) and the counter-element can be manufactured in one piece. Furthermore, at least two counter-elements may be connected by the structural element(s). The structural element(s) may also be formed on an electrically insulating layer structure. The respective electrically insulating layer structure may be covering the counter element.

The invention also relates to a method for manufacturing a component carrier according to one of the preceding claims; comprising the steps;
- providing a stack comprising at least one electrically conductive layer structure and a plurality of electrically insulating layer structures ,
- wherein at least one first electrically insulating layer structure is provided at a first main side of the stack and at least one second electrically insulating layer structure is provided at an opposed second main side of the stack
- embedding at least one component in the at least one first electrically insulating layer structure ;
- at least one counter-element in the at least one second electrically insulating layer structure, wherein said at least one counter-element is configured and positioned to affect the stack in opposition of the embedded component.

The at least one electrically conductive layer structure and the plurality of electrically insulating layer structures can be formed by building up at least one layer structure of the one electrically conductive layer structure and layer structures of the at least one first electrically insulating layer structure at the first main side of the stack and layer structures of the at least one second electrically insulating layer structure on the second main side of the stack.

Preferably a first cavity can be formed in the at least one first electrically insulating layer structure and wherein at least one component may be embedded in the first cavity and wherein a second cavity can be formed in the at least one second electrically insulating layer structure wherein the at least one counter-element may be embedded in the second cavity.

The at least one component may be embedded by arranging the component before building up the layer structures of the at least one first electrically insulating layer structure at the first main side of the stack and/or the at least one counter-element may be embedded by arranging the counter-element before building up the layer structures of the at least one second electrically insulating layer structure on the second main side of the stack.

According to an embodiment, the first cavity may be formed after building up the layer structures of the at least one first electrically insulating layer structure at the first main side and/or the second cavity may be formed after building up the layer structures of the at least one second electrically insulating layer structure on the second main side of the stack.

In the context of the present application, the term "component" may particularly denote an electronic component which is configured to be mounted on and/or to be embedded into a component carrier, wherein the component may further in particular be configured to be electrically connected to the component carrier. A component can be an inorganic component (such as, for example, a semiconductor component) or a component comprising inorganic material and/or metal material and/or a combination thereof or consisting thereof.

Additionally or alternatively, a component may be a physical body configured to be mounted on and/or to be embedded into a component carrier. For example, said physical body may be one of: a copper block, a glass block, a ceramic block, an inlay, a bridge, a PCB, an IC substrate, an interposer.

A component may in particular be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminum oxide (Al₂O₃) or aluminum nitride (AlN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (In-GaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microoptoelectromechanical system (MOEMS), a microprocessor, a capacitor, a resistor, an inductance, a battery, a switch, a camera, an antenna, a logic chip, and an energy harvesting unit. However, in addition or alternatively, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component. Additionally or alternatively, the component may comprise a polymer waveguide and/or (optical) lenses and/or collimators and/or ferrules.

The counter element may be one of the listed examples above, however in general may be a body comprising physical properties counteracting to the warpage behavior of the component.

Preferably the counter-element may be provided with a shape and/or material that may be easy and/or cheap to manufacture or obtain, which still provides the counter-function and is suitable to be provided in the stack.

In general, a position of the counter-element in the stack may be determined or adjusted (for example, with respect to at least one center plane as mentioned before) in order to provide a specific positioning of the desired counter-function. The respective position of the counter-element may also be simulated, for example with respect to known warpage parameters caused by the component. For the sake of completeness, it should be mentioned that the material properties of the counter-element can also be included in a simulation.

It is understood that a "material" in the sense of the present application may comprise one or more type(s) of element(s). It is further understood, that even if two of the (first, second and third) materials comprise the same element, but differ in another element and/or in composition and/or in element ratio, they are considered as being different from each other. For example, if the first material is a CuSn alloy and second material is Cu, they are of course different to each other.

In the context of the present application, the term "component carrier assembly" is understood as a combination of a component carrier and at least one electronic component.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote an arrangement of multiple planar layer structures which are mounted in parallel on top of one another. It may comprise at least one electrically insulating layer structure and at least one electrically conductive layer structure. For example, the stack may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high-density product. The stacking direction (height/thickness) may be arranged in the vertical direction z. Further, the stacking direction may be perpendicular to the two directions of main extension (along x and y) of the (plate-shaped) component carrier.

In the context of the present application, the term "layer structure" may particularly denote a continuous or discontinuous layer, a patterned layer or a plurality of non-consecutive islands within a common plane. A plurality of such layers, parallel stacked one upon the other, may form the stack in the vertical direction.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

Preferably, the component carrier assembly is a printed circuit board (PCB) and/or a substrate (such as an IC substrate) and/or an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the at least one electrically insulating layer structure comprises at least one of the group, consisting of a resin or a polymer, such as epoxy resin, cyanate ester resin, benzocyclobutene resin, bismaleimidetriazine resin, polyphenylene derivate (for example based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, for example fibers impregnated with the above-mentioned resins is called prepreg. These prepregs are often named after their properties for example FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, molybdenum, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

According to a further possible embodiment, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

To provide better understanding of the invention, the invention is explained in more detail with the aid of the following figures.

The following is shown in a strongly simplified, schematic representation:
- Fig. 1: A schematic view of a first embodiment of a component carrier;
- Fig. 2: a second embodiment of a component carrier;
- Fig. 3: a third embodiment of a component carrier;
- Fig. 4: a first top view of a possible embodiment of a component carrier;
- Fig. 5: a second top view of a possible embodiment of a component carrier;
- Fig. 6: a fourth embodiment of a component carrier with a plurality of components;
- Fig. 7: a fifth embodiment of a component carrier with a plurality of components
- Fig. 8: a schematic view of a sixth embodiment of a component carrier.

As an introduction, it should be noted that in the embodiments described in different ways, identical parts or method steps are indicated with identical reference numbers or identical component designations; at the same time, the disclosures contained in the entire description may be analogously applied to identical parts with identical reference numbers or identical component designations. Moreover, the position indications chosen in the description, such as at the top, at the bottom, laterally, etc. refer to the figure which is directly represented and described; and if a position changes, said position indications are to be applied analogously to the new position.

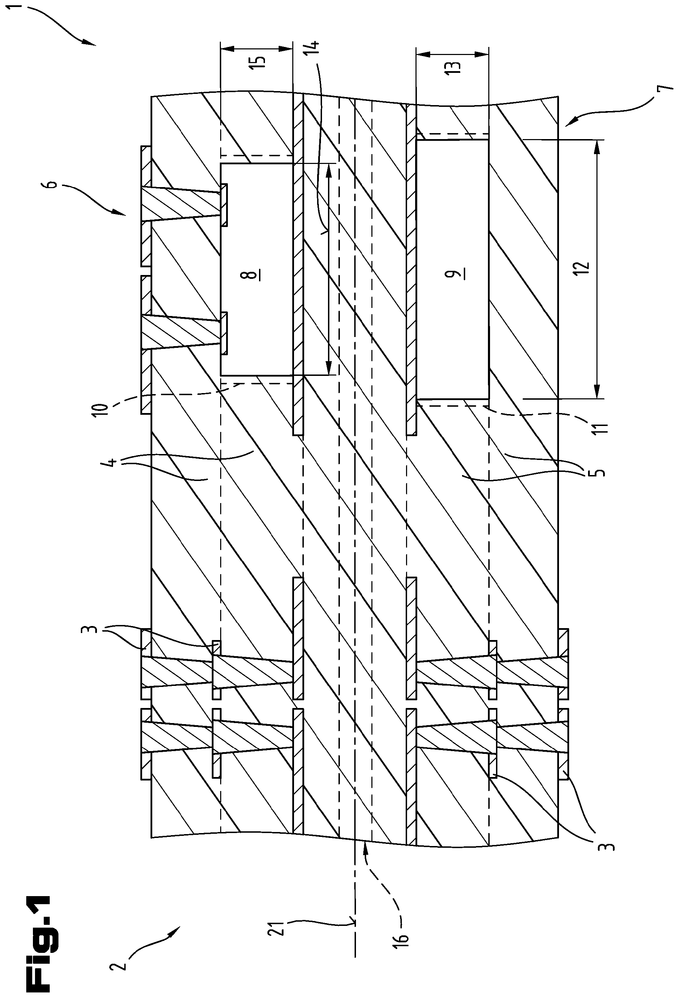

Fig. 1 shows a schematic view of a possible embodiment of a component carrier 1.

The component carrier 1 comprises a stack 2 with at least one electrically conductive layer structure 3 and a plurality of electrically insulating layer structures 4,5, wherein at least one first electrically insulating layer structure 4 is provided at a first main side 6 of the stack 2 and at least one second electrically insulating layer structure 5 is provided at an opposed second main side 7 of the stack 2.

At least one component 8 is embedded in the at least one first electrically insulating layer structure 4.

According to the invention, at least one counter-element 9 can be embedded in the at least one second electrically insulating layer structure 5, wherein said at least one counter-element 9 is configured and positioned to affect the stack 2 in opposition of the embedded component 8. As already mentioned, the counter-element 9 can be provided to counterbalance the influence of the component 8 on the stack, in particular its physical influence.

Preferably the at least one counter-element 9 can be configured and positioned to mechanically affect the stack 2 in opposition of the mechanical affection of the stack 2 by the embedded at least one component 8.

The at least one component 8 is electrically connected to the respective first main side 6 of the stack 2 by the at least one electrically conductive layer structures 3. Additionally or alternatively, the at least one component may be electrically connected to the opposed second main side of the stack (not shown).

The counter-element 9 may comprise electrically insulating material. Additionally or alternatively, the counter-element 9 may comprise electrically insulating material and/or thermally conductive material.

The at least one counter-element 9 may be not connected with a surface of the component carrier 1, as it can be seen in Fig. 1, for example.

Preferably; the at least one component 8 can be embedded in a first cavity 10 in the at least one first electrically insulating layer structure 4 and the at least one counter-element 9 can be embedded in a second cavity 11 in the at least one second electrically insulating layer structure 5 as indicated by the dashed lines.

According to a further embodiment, one of the elements; comprising i) the at least one component 8 and ii) the at least one counter-element 9; may be embedded in a plurality of first electrically insulating layer structure 4 or the second electrically insulating layer structure 5, wherein the other one can be embedded in one of the first electrically insulating layer structure 4 or the second electrically insulating layer structure 5, which will be described later.

The respective layer structures of the first electrically insulating layer structure 4 compared to the second electrically insulating layer structure 5 may have the same layer thickness. Additionally or alternatively, the first electrically insulating layer structure 4 compared to the second electrically insulating layer structure 5 may have different layer thickness. Furthermore, the at least one component 8 and the at least one counter-element 9 may be of a different material or of a different material composition or may have different material properties, especially with respect to their stiffness and density.

Independent of the embodiment shown, the first electrically insulating layer structure 4 compared to the second electrically insulating layer structure 5 may have the same material properties, especially with respect to their stiffness and density.

Alternatively, the first electrically insulating layer structure 4 compared to the second electrically insulating layer structure 5 may have different material properties, especially with respect to their stiffness and density.

The at least one counter-element 9 can also be in contact with at least one electrically conductive layer structure 3 of the stack 2. Alternatively, the counter counter-element 9 can be separated from the at least one electrically conductive layer 3, preferably by means of the insulating layer structure 5.

As indicated in Fig. 1, the at least one counter-element 9 may have a different planar extension 12 and with respect to the planar extension 14 of the at least one component 8. The counter-element 9 may also have a different vertical extension 13 with respect to the vertical extension 15 of the component 8.

The surfaces of the opposed respective at least one component 8 and the at least one counter-elements 9 may at least partially overlap one to each other from a frontal vertical view.

According to a possible embodiment, a ratio of the volume of the at least one component 8 with respect to the volume of the at least one respective counter-element 9 does not exceed a difference of 30%.

The material of the at least one component 8 and the material of the at least one respective counter-element 9 each may have a young module that differs from each other by a maximum of 50% and/or may have a Coefficient of Thermal Expansion that differs from each other by a maximum of 50%.

In the context of the invention, it should be mentioned that the reference to the component and the respective counter-element refers to that counter-element that is provided to affect the warpage behavior imparted by the component.

Independent of the embodiment shown; the component carrier 1 may comprise a central structure 16 between the at least one first electrically insulating layer structure 4 and the at least one second electrically insulating layer structure 5.

The central structure 16 may comprise only one layer structure, or alternatively, a plurality of layer structures. The central structure 16 may comprise electrically conductive layer structures and/or electrically insulating layer structures.

The stack 2 can comprise the same amount of layer structures on one side above the central structure 16 with respect to the amount of layer structures on the other side below the central structure 16.

The component carrier 1 may comprise a coreless central structure.

Independent of the embodiments shown; a first center plane 20 (of the stack) in general may be arranged horizontal (or planar); preferably in a middle of the stack between the first electrically insulating layer structure 4 and the at least one second electrically insulating layer structure 5.

The component carrier 1 may comprise a core structure 17 between the at least one first electrically insulating layer structure 4 and the at least one second electrically insulating layer structure 5. Additionally or alternatively, the central structure 16 may comprise the core structure 17. The at least one first electrically insulating layer structure 4 may be provided at a first side of the core structure 17 and the at least one second electrically insulating layer structure 5 may be provided at an opposed second side of the core structure 17.

Generally the component carrier 1 may comprise a plurality of first electrically insulating layer structures 4 and/or a plurality of electrically conductive layer structures 3 on the first main side 6.

On the second main side 7, the component carrier 1 may comprise a plurality of second electrically insulating layer structures 5 and/or a plurality of electrically conductive layer structures 3.

According to one possible embodiment; a plurality of counter-elements 9 can be provided for the at least one component 8 or a plurality of components 8 can be provided for the at least one counter-element 9.

Independent of the embodiment shown; the electrically conductive layer structure 3 may comprise further conductive elements; traces; vias, and other elements as known from the prior art. Additionally or alternatively, the electrically conductive layer structure 3 may be an electrically conductive and thermally conductive layer structure. For example, the electrically conductive layer structure may comprise metal in particular copper. Additionally or alternatively, the electrically conductive layer structure 3 may comprise a surface finish, for example gold, and/or silver and/or tin. The electrically insulating layer structure 4, 5 may comprise a solder resist.

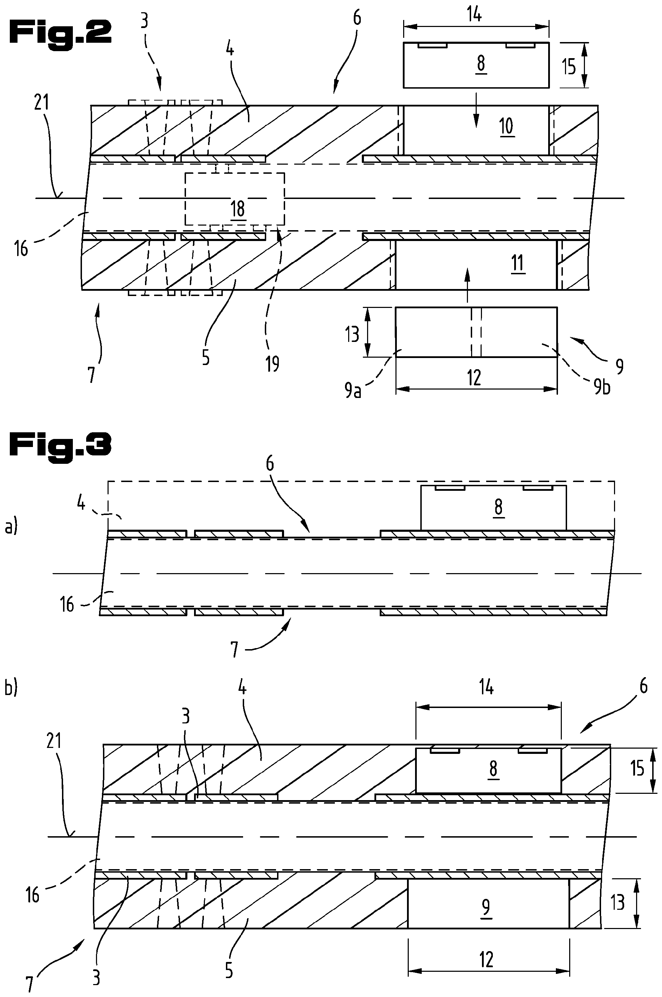

Fig. 2 and 3 show a second and third possible embodiment of a component carrier, wherein equal reference numbers/component designations are used for equal parts as before in figure 1. In order to avoid unnecessary repetitions, it is pointed to/reference is made to the detailed description in figure 1 preceding it.

As indicated by dashed lines in Fig. 2, for example; two counter-elements 9a and 9b may be provided for the respective component 8. The counter-elements 9 can be placed next to each other, preferably separated from each other to provide a space between the two counter-elements that can be filled with material, preferably an embedding material.

Alternatively, the counter-element 9 may be a single counter-element as shown without the dashed lines.

According to Fig. 2, the at least one counter-element 9 may be inserted into a cavity 11 that is formed in the second electrically insulating layer structure 5 to accommodate the counter-element 9 and/or the at least one component 8 may be inserted into the cavity 10 that is formed in the first electrically insulating layer structure 4 to accommodate the component 8.

The first cavity 10 may be formed in the at least one first electrically insulating layer structure 4, wherein at least one component 8 is embedded in the first cavity 10, preferably after forming the first cavity, and/or the second cavity 11 may formed in the at least one second electrically insulating layer structure 5 wherein the at least one counter-element 9 can be embedded in the second cavity 11 preferably after forming the second cavity.

The first cavity 10 may be formed after building up at least one first electrically insulating layer structure 4 at the first main side 6 and/or the second cavity 11 may be formed after building up the at least one second electrically insulating layer structure 5 on the second main side 7 of the stack 2.

As further indicated by dashed lines, the (parts of) electrically conductive layer structure 3 that has to be provided in the first electrically insulating layer structure 4 (or in the second insulating layer structure 5) may be formed after providing the component 8 (or the counter-element 9).

According to Fig. 3, the component 8 may be provided at the first main side 6, as shown in Fig. 3 a) wherein, the component 8 may be embedded in the first electrically insulating layer structure 4 by a built-up structure or the like, as it can be seen in Fig. 3 b) The at least one counter-element 9 may be embedded in the second electrically insulating layer structure 5, preferably by a built-up structure. According to a possible embodiment, the counter-element 9 may be arranged on the second main side 7 before applying the second electrically insulating layer structure 5, and after embedding the component 8 in the first electrically insulation layer structure 4.

The embedding may be achieved by an encapsulation of the respective counter-element 9 or the respective component 8, preferably by a resin material.

It should be mentioned that the order described above alternatively may be provided vice-versa, so that the counter-element 9 may be provided on the second main side 7 and embedded in the second electrically insulating layer structure 5, wherein the component 8 is provided or placed at the first main side 6 and embedded in the first electrically insulating layer structure 4 after embedding the counter-element 9 .The at least one component 8 and/or the at least one counter-element 9 may be embedded by arranging the component 8 and/or the counter-element 9 before building up the first electrically insulating layer structure(s) 4 at the first main side 6 of the stack 2 and/or before building up the second electrically insulating layer structure(s) 5 on the second main side 7 of the stack 2.

According to a further possible embodiment; the counter-element 9 may be formed within the second electrically insulating layer structure 5 by applying a semi-cured material, for example on the counter-element 9. The semi-cured material may be fully cured after the counter-element has been inserted.

The respective component 8 may be arranged on the first main side 6 before applying the first insulating layer structure(s) 4.

According to both embodiments of Fig. 2 and 3, additional layer structures (not shown) may be formed on the component 8 and/or on the counter-element 9 one the respective main side 6,7; preferably embedding the component 8 and/or the counter-element 9 in the stack.

The at least one electrically conductive layer structure 3 and the plurality of electrically insulating layer structures 4,5 may be formed by building up at least one electrically conductive layer structure 3 and at least one first electrically insulating layer structure 4 at the first main side 6 of the stack 2 and at least one electrically conductive layer structure 3 and at least one second electrically insulating layer structure 5 on the second main side 7 of the stack 2.

As indicated in Fig. 2 and 3; independent of the embodiment shown; the component carrier may comprise a central structure 16.

Furthermore, at least one inner cavity 19 may be formed in the central structure 16 and/or in the core structure17; wherein a further component 18 can be arranged in the inner cavity 19 as indicated in Fig. 2.

The at least one first electrically insulating layer structure 4 and/or the at least one second electrically insulating layer structure 5 may be provided by a build-up on at least one side of the core structure 17.

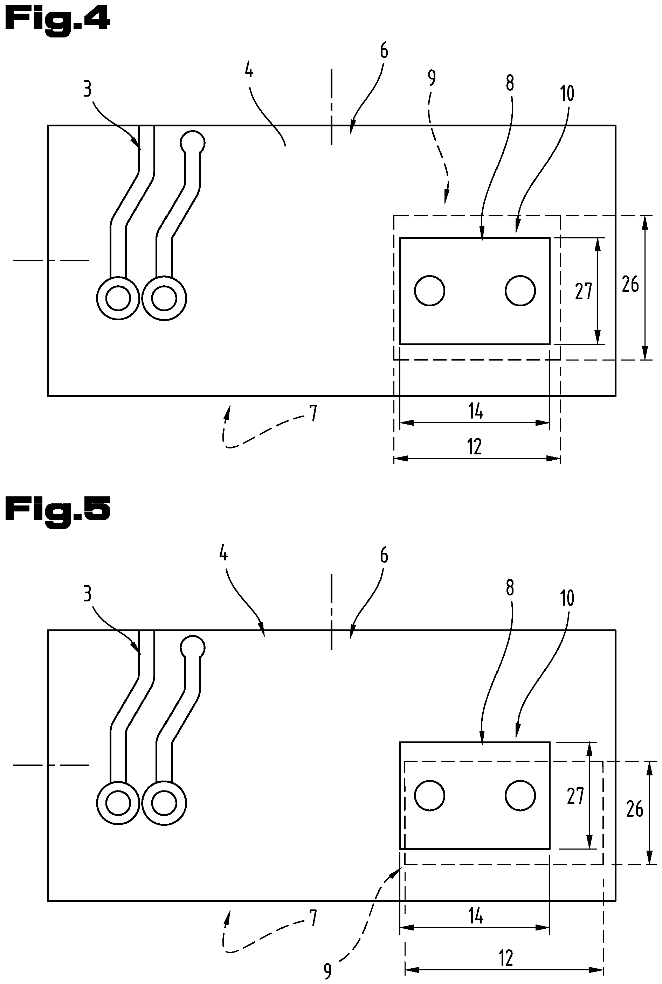

Fig. 4 and 5 show possible embodiments of the component carrier in a top view on the first main side 6.

The counter-element 9 at least partially overlap the component 8.

As indicated in Fig. 4, the at least one counter-element 9 can overlap the at least one component 8 on each of its surfaces from a top view on the stack. Therefore; the counter-element 9 may have a second planar extension 26 preferably perpendicular its first planar extension 12, wherein the planar extension 12, 26 of the counter-element 9 may overlap the component 8 with respect to its first planar extension 14 and second planar extension 27.

As shown as an example in Fig. 5; it may also be possible that the at least one component 8 and the respective at least one counter-element 9 can overlap each other at least partially.

At least one of the planar extensions 12, 26 of the counter-element 9 may be different from at least one of the planar extensions 14,27 of the respective component 8.

The planar extension 12, 26 of the counter-element 9 can also be equal (at least in one direction) to the planar extension 14, 27 of the component 8, wherein they can overlap or be offset each other, when the counter-element 9 and the component 8 may be not arranged in alignment with each other (from a top view).

In a further possible embodiment, the counter-element 9 and the component 8 may be arranged to each other in such way that they do not overlap at all from a top view (not shown).

For the sake of completeness, it should be mentioned that the embodiments as shown in Fig. 4 and 5 are provided for easier understanding and the invention is not limited thereto. The same applies to the geometry of the components and counter-elements, which may also have a different shape than it is shown in the schematic view of the figures. Additionally or alternatively, the at least one component 8 and the at least one counter-element 9 may have the same geometrical shape.

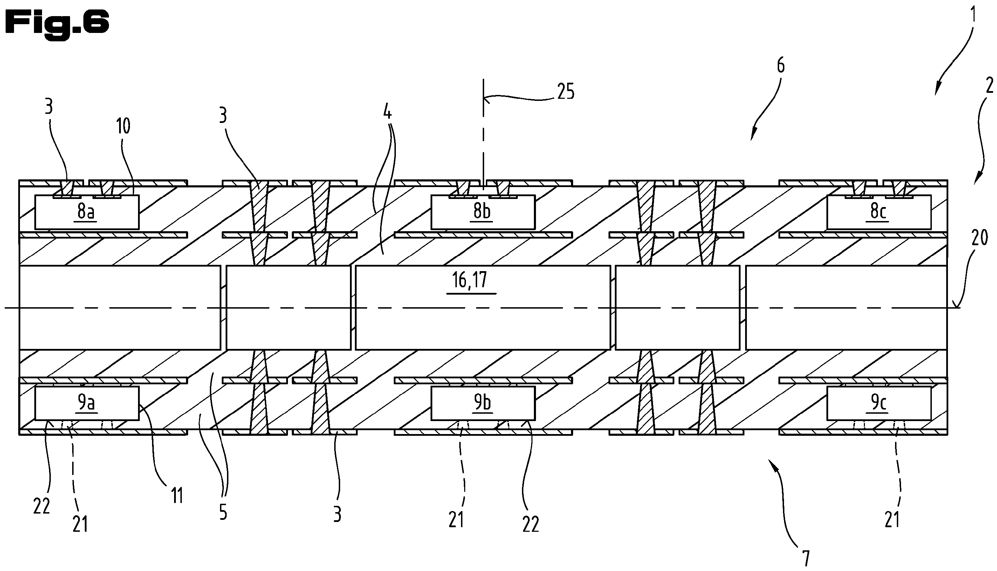

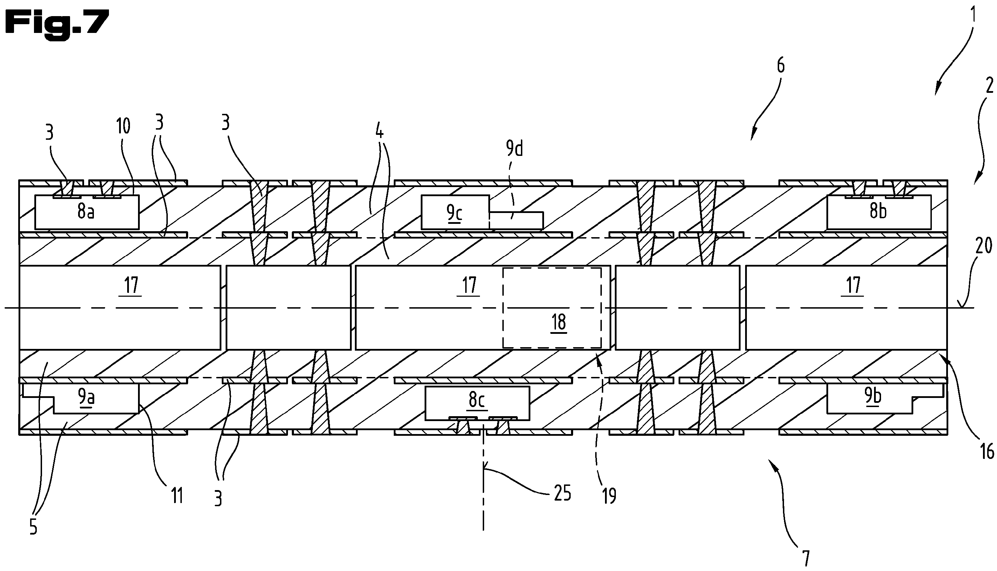

Fig. 6 and 7 show a fourth and fifth possible embodiment of a component carrier; with a plurality of components 8 and a plurality of counter-elements 9, wherein equal reference numbers/component designations are used for equal parts as before in figures 1 to 5. In order to avoid unnecessary repetitions, it is pointed to/reference is made to the detailed description in figures 1 to 5 preceding it.

A plurality of components 8 may be provided on at least one or both of the main sides; comprising the first main side 6 and the second main side 7 of the stack 2, wherein several respective counter-elements 9 are provided on the respective opposed main sides 6,7 of the stack 2 for each component 8 of the plurality of components 8. According to this embodiment, the plurality of components 8 and the plurality counter-elements 9 may have the same total number of components 8 and counter-elements 9 as it is indicated in Fig. 6.

Also independent of the embodiment shown, the at least one counter-element 9 may have an asymmetrical shape. An asymmetrical shape can be used to provide different material properties of the counter-element 9 in different directions. The asymmetrical shape may comprise an enforcement element; like a web or bar; which extends in a planar direction from the counter-element. Alternatively, an asymmetrical shape may also be formed by multiple counter-elements of different shapes, preferable put in contact with each other.

A further advantage of an asymmetrical shape can be an improved embedding function of the counter-element 9 in the stack 2. The asymmetrical shape may provide an enlarged surface and/or further contours for embedding the counter-element 9 in the stack 2.

Furthermore; a first counter-element 9a of the plurality of counter-elements 9 may have an asymmetrical shape; wherein at least a second counter-element 9b of the plurality of counter-elements 9 may also have an asymmetrical shape; preferably symmetrically arranged to the first one counter-element 9 with respect to a vertical plane 25 - as it can be seen in Fig. 7.

The vertical plane may refer to a second center plane or third center plane as described above.

As indicated in Fig. 7 by dashed lines with an possible additional counter-element 9d, the total number of components 8 and counter-elements 9 may be not equal.

At least one of the respective counter-element 9 of the plurality of counter-elements 9 may have a different planar extension 12 and/or vertical extension 13 with respect to at least one component 8.

At least one of the respective counter-elements 9 of the plurality of counter-elements 9 may have a different planar extension 12 and/or vertical extension 13 with respect to at least one other counter-element 9 of the plurality of counter-elements 9.

Independent of the embodiments shown in Fig. 1 to 7; the at least one counter-element 9 may comprise an active element or a passive element. An active element may also have conductive properties with respect to the stack; or may be used for heat transfer. A passive element may have no conductive function. Furthermore, the passive element may just provide mechanical features.

The at least one counter-element 9 can comprise one of the following elements;
- a component; in particular an electric component or a bridge;
- a dummy component;
- a metal structure;
- a layer structure; in particular an inlay;
- at least one second conductive layer structure with a different density with respect to the at least one electrically conductive layer structure 3, preferably a higher density with respect to the least one electrically conductive layer structure 3;
- a sub-stack, in particular an interposer.

As said before, the counter-element 9 may also be provided by a defect component.

The counter-element 9 may also comprise a combination of materials or consist of only one material.

According to an embodiment; the component carrier 1 may comprise a core structure 17 between the at least one first electrically insulating layer structure 4 and the at least one second electrically insulating layer structure 5; as shown in Fig. 6 and 7. A core structure 17 may comprise one core structure or a plurality of core structures.

A core structure 17 may be a central structure 16 that can be provided by a layer structure or a plurality of layer structures with a predefined shape/geometry, wherein the stack is provided or formed on the core structure in order to provide the component carrier 1. The core structure 17 may also comprise different materials along a planar direction with respect to the center plane 20.

Preferably the at least one first electrically insulating layer structure 4 may be provided at a first side of the core structure 17 and the at least one second electrically insulating layer structure 5 is provided at an opposed second side of the core structure 17. Preferably the first and the second side of the core structure 17 may be oriented analog to the first and second main side 6,7.

The at least one first electrically insulating layer structure 4 and/or the at least one second electrically insulating layer structure 5 may be provided by a build-up structure on at least one side of the core structure 17. The build-up structure may comprise several steps of forming layer structures, for example a multi-layer-structure.

Independent of the embodiments shown; a vertical position of the at least one component 8 and/or the respective at least one counter-element 9 may be decentered towards a respective external surface (of the first main side 6 or the second main side 7) of the stack 2 with respect to a center plane 20 of said stack 2.

Additionally or alternatively, a horizontal position of the at least one at least one component 8 and/or the respective at least one counter-element 9 may be decentered towards a respective external surface (a lateral side of the stack 2, for example between the first main side 6 and the second main side 7) of the stack 2. The decentered horizontal position may be provided in at least one direction parallel to the center plane 20.

Preferably the at least one component 8 and the respective counter-element 9 may be mirrored-placed one to each other with respect to a center plane 20 of the stack 2, as it can be seen in Fig. 6. A mirrored-placed arrangement may also be provided with a possible alternating arrangement of the components 8 and the respective counter-elements 9 on both main sides (not shown).

According to one embodiment the planar extension of the at least one counter-element 9 at least partially inversely overlaps the planar extension of the at least one component 8.

Preferably the volume of the counter-elements 9 may inversely overlap the volume of the respective at least one component 8 by at least 50 % of the volume of the component 8.

Generally, a volume may be the space that the component 8 or the counter-element 9 geometrically occupies in the respective electrically insulating layer structure (4,5).

According to an preferred embodiment, the at least one component 8 can be embedded at the same position in an inverse order of at least one layer of the first electrically insulating layer structure 4 with respect to the position of at least one layer of the second electrically insulating layer structure 5 where the at least one counter-element 9 is embedded. The inverse order may refer to an order of the layer structures of the stack 2 with respect to a vertical direction - starting from a surface of the component carrier on the first main side to a surface of the component carrier on the opposite second main side.

In one embodiment; at least one component 8 and the at least one counter-element 9 may have the same geometrical shape - at least with respect to their outer contour; preferably mirrored to each other witch respect to the center plane.

Furthermore, a first component of a plurality of components 8 may have the same geometrical shape with respect to its respective counter-element of a plurality of counter-elements 9, wherein at least a second component of the plurality of components may have a different shape to its respective counter-element of the plurality of counter-elements.

According to one possible embodiment, the at least one counter-element 9 can be electrically insulated from the electrically conductive layer structures 3 of the stack 2. As it can be seen in Fig. 6, independent of the embodiment shown; the plurality of counter-elements 9 can be electrically insulated from the electrically conductive layer structures 3 of the stack 2.

According to a further possible embodiment, independent of the embodiment shown, at least one further structural element 21 can be provided in an area of the at least one counter-element 9, wherein the structural element 21 is configured to affect the stack 2 in opposition of at least a part of the electrically conductive layer structure 3 that is provided in an area of the at least one component 8.

The at least one structural element 21 may be formed on an outer surface 22 of the at least one counter-element 9. For example, if the counter-element 9 may be formed by a dummy element; the structural element(s) 21 may be integrally formed with the counter-element 9. The structural element(s) 21 may also be formed on an insulating layer 24, which insulating layer 24 may be covering the counter element.

Furthermore, the structural elements 21 may be inserted into the electrically insulating layer structure wherein the counter-element 9 has to be embedded, preferably in a cavity or the like.

A vertical position of the at least one component 8 and/or a vertical position of the respective at least one counter-element 9 may be decentered towards the respective external surface on the respective main side 6,7 of the stack 2 with respect to a center plane 20 of said stack 2. Additionally or alternatively, the at least one component 8 and the respective counter-element 9 may be mirrored -placed one to each other with respect to a center plane 20 of the stack 2.

In other words, the volume of the at least one counter-elements 9 may (inversely) overlap the volume of the respective at least one component 8 of at least 50 % the of the volume of the component 8.

When a plurality of counter-elements 9 is provided; a plurality of structural elements 21 may also be provided for the plurality of counter-elements 9.

Optionally, at least two counter-elements 9 may be mechanically connected to each other by the structural element 21.

Also independent of the embodiment shown; the structural element(s) 21, may have a planar extension that is greater than the planar extension of the counter-element 9. The structural element(s) 21 may be designed in such way that the planar extension of structural element(s) 21 corresponds to an (planar) extension of at least one layer of the conductive layer structure 3 on the other main side of the stack 2.

According to a possible embodiment, the structural element(s) 21 may comprise at least partially a dummy design of the opposite conductive layer structure.

For the sake of good order, it should finally be noted that, for better understanding, some of the facts shown in the figures have been represented unscaled and/or enlarged and/or in reduced size.

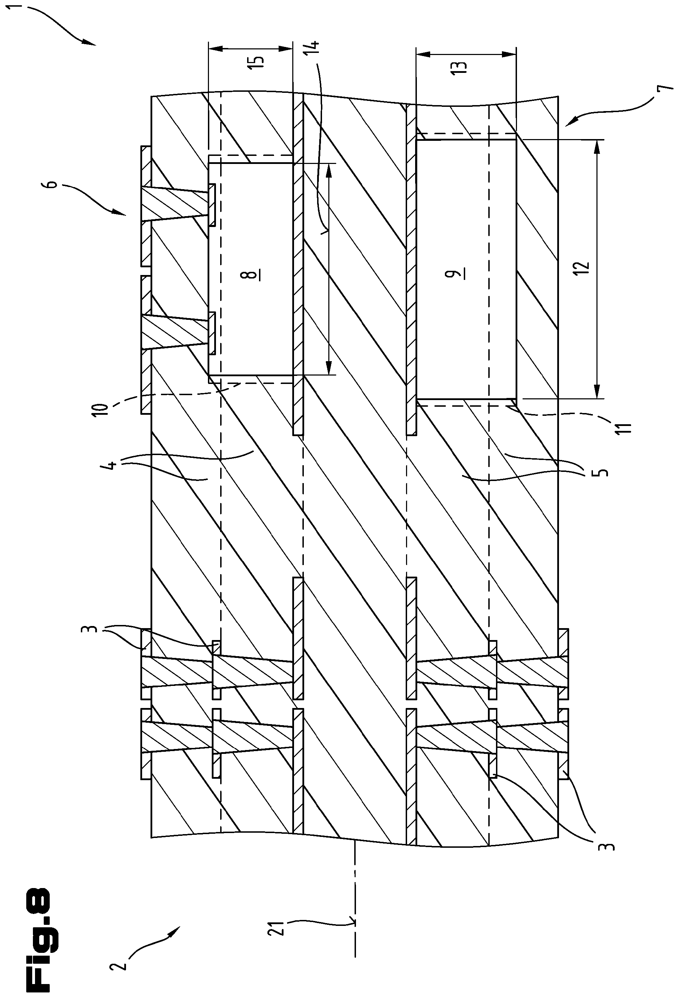

Fig. 8 shows a sixth possible embodiment of a component carrier; with a plurality of components and a plurality of counter-elements 9, wherein equal reference numbers/component designations are used for equal parts as before in figures 1 to 7. In order to avoid unnecessary repetitions, it is pointed to/reference is made to the detailed description in figures 1 to 7 preceding it.

The at least one component 8 and/or the at least one counter-element 9 may be embedded in a cavity 10,11 that is formed in a plurality of electrically insulating layer structure 4,5.

As shown in Fig. 8, both, the at least one component 8 and the at least one counter-element 9 may be embedded in a respective cavity 10,11 that is formed in a plurality of the respective insulating layer structure 4,5.

Furthermore, the at least one component 8 or the at least one counter-element 9 may be embedded in a respective cavity 10,11 that is formed in one layer of the respective electrically insulating layer structure 4,5 (for example, as shown in Fig. 1), wherein the other one is embedded in a plurality of electrically insulating layer structures 4,5. According to this embodiment; one of the elements; comprising i) the at least one component 8 and ii) the at least one counter-element 9; may be embedded in the plurality of the first electrically insulating layer structure 4 or the second electrically insulating layer structure 5, wherein the other one can be embedded in only one electrically insulating layer structure of the first insulating layer structure 4 or the second insulating layer structure 5.

For example, one of the elements, comprising i) the at least one component 8 and ii) the at least one counter-element 9; may have other dimensions, e.g. a higher vertical extension than the other one.

Implementation of the invention is not limited to the preferred embodiments shown in the figures and described above. Instead, a multiplicity of variants is possible which use the solutions shown and the principle according to the invention, whose scope is defined by the appended claims.

### List of reference

- 1: component carrier
- 2: stack
- 3: electrically conductive layer structure
- 4: first insulating layer structure
- 5: second insulating layer structure
- 6: first main side
- 7: second main side
- 8: component
- 9: counter-element
- 10: first cavity
- 11: second cavity
- 12: planar extension
- 13: vertical extension
- 14: planar extension
- 15: vertical extension
- 16: central structure
- 17: core
- 18: further component
- 19: inner cavity
- 20: center plane
- 21: structural element
- 22: outer surface
- 23: conductive layer
- 24: insulating layer
- 25: vertical plane
- 26: second planar extension
- 27: second planar extension

## Claims

1. A component carrier (1) comprising
- a stack (2) comprising at least one electrically conductive layer structure (3) and a plurality of electrically insulating layer structures (4,5),
- wherein at least one first electrically insulating layer structure (4) is provided at a first main side (6) of the stack (2)
- at least one second electrically insulating layer structure (5) is provided at an opposed second main side (7) of the stack (2)
- at least one component (8) that is embedded in one between the at least one first electrically insulating layer structure (4) and the at least one second electrically insulating layer structure (5);
- at least one counter-element (9) that is embedded in the other one of the at least one first electrically insulating layer structure (4) and the at least one second electrically insulating layer structure (5), wherein said at least one counter-element (9) is configured and positioned to affect the stack (2) in opposition of the embedded component (8).

2. A component carrier (1) according to claim 1, wherein the at least one component (8) is electrically connected to at least one of the main sides, in particular the first main side (6) and/or the opposed second main side (7) of the stack (2), and/or wherein the at least one counter-element (9) is electrically insulated from the electrically conductive layer structures (3) of the stack (2).

3. A component carrier (1) according to one of the claims 1 to 2, wherein the at least one component (8) is embedded in a first cavity (10) that is formed in one or in a plurality of one between the at least one first electrically insulating layer structure (4) and the at least one second electrically insulating layer structure (5), and/or the at least one counter-element (9) is embedded in a second cavity (11) that is formed in one or in a plurality of the other one of the at least one first electrically insulating layer structure (4) and the at least one second electrically insulating layer structure (5).

4. A component carrier (1) according to one of the claims 1 to 3, wherein the at least one counter-element (9) is in contact with at least one electrically conductive layer structure (3) of the stack (2).

5. A component carrier (1) according to one of the claims 1 to 4, wherein a plurality of counter-elements (9) is provided for the at least one component (8) and/or a plurality of components (8) is provided for the at least one counter-element (9).

6. A component carrier (1) according to one of the claims 1 to 5 , wherein the at least one counter-element (9) comprises at least one of the following elements;
- a component; in particular an electric component or a bridge;
- a dummy component;
- a component for testing purposes in particular a daisy-chain component
- a metal structure;
- a layer structure; in particular an inlay;
- at least one second conductive layer structure with a different *(high)* density with respect to the at least one electrically conductive layer structure (3);
- a sub-stack, in particular an interposer.

7. A component carrier (1) according to one of the claims 1 to 6, wherein the component (8) carrier (1) comprises a central structure (16) between the at least one first electrically insulating layer structure (4) and the at least one second electrically insulating layer structure (5), in particular the central structure (16) comprise one layer structure or a plurality of layer structures; and/or the stack (2) comprises the same amount of layer structures on one side above the central structure (16) with respect to the amount of layer structures on the other side below the central structure (16).

8. A component carrier (1) according to one of the claims 1 to 7, wherein the component carrier (1) comprises a core structure (17) between the at least one first electrically insulating layer structure (4) and the at least one second electrically insulating layer structure (5), in particular the at least one first electrically insulating layer structure (4) is provided at a first side of the core structure (17) and the at least one second electrically insulating layer structure (5) is provided at an opposed second side of the core structure (17) and/or wherein the at least one first electrically insulating layer structure (4) and/or the at least one second electrically insulating layer structure (5) comprises a build-up structure on at least one side of the core structure (17).

9. A component carrier (1) according to claim 7 or 8, wherein at least one inner cavity (19) is formed in the central structure (16) and/or in the core structure (17).

10. A component carrier (1) according to claim 9, wherein a further component (18) is embedded in the inner cavity (19) that is formed in the central structure (16) and/or in the core structure (17).

11. A component carrier (1) according to one of the claims 1 to 10, wherein the surfaces of the opposed respective at least one component (8) and the at least one counter-elements (9) at least partially overlap one to each other from a frontal vertical view.

12. A component carrier (1) according to one of the claims 1 to 11, wherein a ratio of the volume of the at least one component (8) with respect to the volume of the at least one respective counter-element (9) does not exceed a difference of 30%.

13. A component carrier (1) according to one of the claims 1 to 12, wherein the material of the at least one component (8) and the material of the at least one respective counter-element (9), have a young module and/or a Coefficient of Thermal Expansion that differs from each other by a maximum of 50%.

14. A component carrier (1) according to one of the claims 1 to 13, wherein a vertical position of the at least one component (8) and/or a vertical position of the respective at least one counter-element (9) is decentered towards a respective external surface on the respective main side (6,7) of the stack (2) with respect to a center plane (20) of said stack (2).

15. A method for manufacturing a component carrier (1) according to one of the preceding claims; comprising the steps;
- providing a stack (2) comprising at least one electrically conductive layer structure (3) and a plurality of electrically insulating layer structures (4,5),
- wherein at least one first electrically insulating layer structure (4) is provided at a first main side (6) of the stack (2) and at least one second electrically insulating layer structure (5) is provided at an opposed second main side (7) of the stack (2)
- embedding at least one component (8) in one between the at least one first electrically insulating layer structure (4) and the at least one second electrically insulating layer structure (5);
- at least one counter-element (9) in the other one of the at least one first electrically insulating layer structure (4) and the at least one second electrically insulating layer structure (5), wherein said at least one counter-element (9) is configured and positioned to affect the stack (2) in opposition of the embedded component (8).
